(19) Europäisches Patentamt

European Patent Office

Office européen des brevets

(11) Veröffentlichungsnummer: **0 426 992 A1**

(12) **EUROPÄISCHE PATENTANMELDUNG**

(21) Anmeldenummer: 90118960.5

(22) Anmeldetag: 04.10.90

(51) Int. Cl.⁵: **H01L 23/522**, H01L 21/56

(30) Priorität: 11.10.89 DE 3933908

(43) Veröffentlichungstag der Anmeldung:
**15.05.91 Patentblatt 91/20**

(84) Benannte Vertragsstaaten:
**DE FR GB IT NL**

(71) Anmelder: **TELEFUNKEN electronic GmbH**
**Theresienstrasse 2**
**W-7100 Heilbronn(DE)**

(72) Erfinder: **Fürthaler, Josef**
**Kastellstrasse 38**
**W-7100 Heilbronn(DE)**

Erfinder: **Gschwend, Friedemann, Dr.**
**Jakob-Haspel-Strasse 19**
**W-7100 Heilbronn(DE)**
Erfinder: **Ohagen, Manfred**
**Jägerhausstrasse 30**
**W-7101 Untergruppenbach(DE)**
Erfinder: **Tomaszewski, Peter, Dr.**
**Schöttlestrasse 26B**
**W-7100 Heilbronn(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) **Verfahren zur Herstellung einer integrierten MOS-Halbleiteranordnung.**

(57) Die Erfindung betrifft ein Verfahren zur Herstellung einer integrierten MOS-Halbleiteranordnung für den Niederfrequenzbereich mit auf einem Halbleitersubstrat (1) angeordneten MOS-Bauelementen und Leitbahnen (7). Erfindungsgemäß wird die zwischen diesen Leitbahnen freiliegende Oberfläche (9) hydrophobiert, wodurch das Entstehen von Leckströmen vermieden wird. Ferner wird bei einer integrierten MOS-Halbleiteranordnung, bei der die MOS-Bauelemente und die Leitbahnen mit einer Schutzschicht (8) abgedeckt sind, erfindungsgemäß die Oberfläche dieser Schutzschicht hydrophobiert. Hierdurch werden sowohl Leckströme als auch parasitäre Kapazitäten verhindert. Dies führt in vorteilhafter Weise zu einer Erhöhung der Schaltungsausbeute.

FIG.2

EP 0 426 992 A1

## VERFAHREN ZUR HERSTELLUNG EINER INTEGRIERTEN MOS-HALBLEITERANORDNUNG

Der Zwang zur Systemintegration führte zur Entwicklung von Schaltungstechniken, die auf die für die Größtintegration (VLSI) geeigneten Standardtechnologien - beispiesweise NMOS- oder CMOS-Technologie - zugeschnitten sind. Eine solche technologiespezifische Schaltungsmethodik stellt beispielsweise die SC- (switched capasitor) Technik dar, mit der PCM-Umsetzer, zeitdiskrete Filter, wie digitale Filter und programmierbare SC-Filter, A/D-Wandler und zeitkontinuierliche Filter realisierbar sind.

Bei den mit der SC-Technik ausgeführten Schaltungen handelt es sich bei den Kondensatoren und den Widerständen um verteilte Elemente, wobei zusätzlich parasitäre Kapaziäten und parasitäre Widerstände entstehen.

Beispielsweise konnte festgestellt werden, daß die Ausbeute bei mit einem n-Wannen-CMOS-Prozeß implementierte SC-Filter bei der Probermessung von Scheiben starken Schwankungen unterworfen war, wobei es sich als unerheblich herausstellte, ob die Scheiben mit einer Schutzschicht versehen oder unbedeckt waren. Ursächlich hierfür wurden Oberflächenleckströme in der Größenordnung von 10 pA entdeckt, die sich aufgrund der durch Wasseraufnahme veränderten Oberfläche bilden können. Zusätzlich bildeten sich bei den mit einer Schutzschicht versehenen Scheiben parasitäre Kapazitäten aus, die über die Oberflächenleckströme verbunden sind.

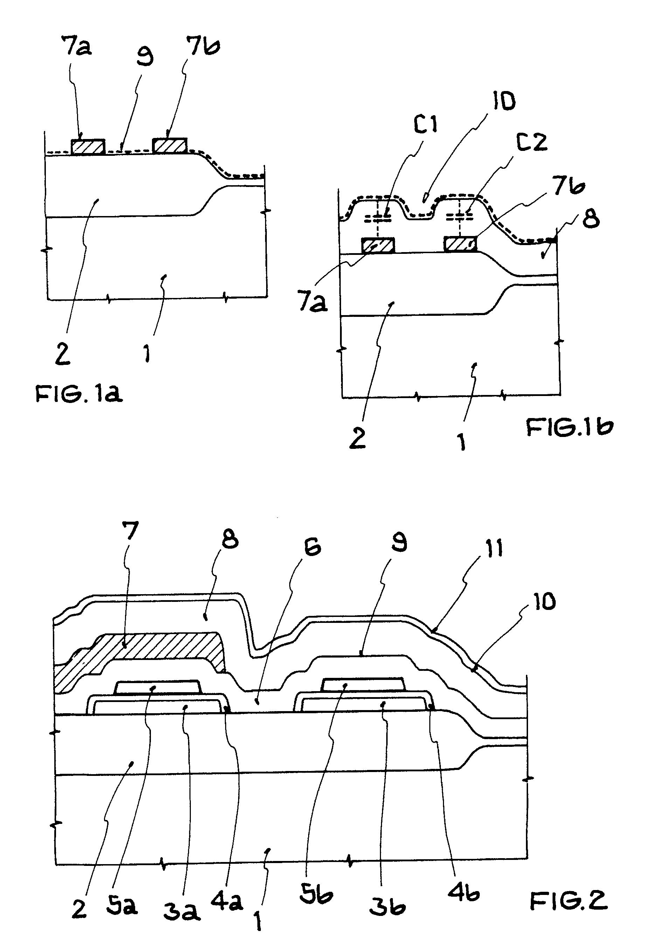

Eine solche Situation zeigen die Figuren 1a und 1b, die jeweils eine schematische Querschnittsansicht einer MOS-Halbleiteranordnung zeigen, wonach jeweils zwei Leitbahnen 7a und 7b auf einer in einem Halbleiterkörper 1 erzeugten Feldoxidschicht 2 aufgebaut sind und aus Aluminium bestehen. Die Anordnung der Figur 1b ist zusätzlich mit einer Schutzschicht 8, beispielsweise aus Siliziumdioxid ($SiO_2$), abgedeckt. Halbleiterscheiben (Wafer), die wie gemäß Figur 1a nicht mit einer Schutzschicht versehen sind, werden vor allem im Entwicklungsstadium eines Schaltkreises hergestellt. Dagegen werden in der Serienfertigung die Halbleiterscheiben entsprechend der Figur 1b mit einer Schutzschicht, die vor allem als Kratzschutz dient, passiviert.

Nach der Herstellung der Halbleiterscheiben, die solche MOS-Halbleiteranordnungen gemäß den Figuren 1a und 1b aufweisen, lagert sich an der hydrophilen Oxid-Oberfläche 9 zwischen den Leitbahnen 7a und 7b bzw. an der hydrophilen $SiO_2$-Oberfläche 10 der Schutzschicht 8 Wasser an, wodurch sich Oberflächenleckströme ausbilden. Die Leckstrompfade sind in den Figuren 1a und 1b als gestrichelte Linien dargestellt. Zusätzlich entstehen aufgrund der dielektrischen Eigenschaften der Schutzschicht 8 parasitäre Kapazitäten, die gemäß der Figur 1b mit den Bezugszeichen C1 und C2 bezeichnet sind und sich insbesondere bei niederen Frequenzen von beispielsweise 175 Hz als störend auswirken können, so daß dies in einer Serienfertigung aufgrund der schon oben erwähnten, nicht reproduzierbaren Meßergebnisse bei der Probermessung zu großen Verlusten in der Schaltungsausbeute führt. Die Probermessung ist jedoch notwendig, da sonst auch die defekten Chips aufgebaut werden, wodurch die Herstellungskosten zu hoch werden.

Die Aufgabe der Erfindung besteht daher darin, ein Verfahren zur Herstellung einer integrierten MOS-Halbleiteranordnung für den Niederfrequenzbereich anzugeben, bei dem die oben erwähnten parasitären Kapazitäten und Oberflächenleckströme nicht mehr auftreten.

Die Aufgabe wird erfindungsgemäß dadurch gelöst, daß einerseits bei einer MOS-Halbleiteranordnung, die nicht mit einer Schutzschicht abgedeckt ist, die zwischen den Leitbahnen freiliegende Oberfläche hydrophobiert wird und andererseits bei einer mit einer Schutzschicht versehenen MOS-Halbleiteranordnung die Oberfläche dieser Schutzschicht hydrophobiert wird. Durch diese erfindungsgemäße Maßnahme werden die genannten Oberflächen hydrophob, stoßen also Wasser ab, wodurch sich dort keine leitfähigen Schichten, die zu den genannten Oberflächenleckströme bzw. parasitären Kapazitäten führen, ausbilden. Hierdurch erhöht sich wesentlich die Schaltungsausbeute, so daß sich die Fertigungskosten für die Halbleiteranordnung beträchtlich verringern.

Die geringeren Fertigungskosten beruhen zudem auch darauf, daß das Vermessen der Halbleiteranordnungen (Probermessung) nicht nach der Verkapselung erfolgt, sondern vor der Verkapselung, also vor dem Zerteilen der die Halbleiteranordnungen tragenden Halbleiterscheibe durchgeführt werden kann.

Bei einer besonders vorteilhaften Ausbildung des erfindungsgemäßen Verfahrens erfolgt die Hydrophobierung mittels Hexamethyldisilazan (($CH_3$)$_3$SiNHSi($CH_3$)$_3$) - im folgenden HMDS genannt.

Weitere vorteilhafte Weiterbildungen der Erfindung sind den Ansprüchen 4 bis 6 entnehmbar.

Die Erfindung soll nachstehend noch anhand eines Ausführungsbeispieles im Zusammenhang mit einer Zeichnung näher erläutert werden. Hierbei zeigt

Figur 2 eine schematische Schnittdarstellung einer mit Hilfe des erfindungsgemäßen Verfahrens hergestellten MOS-Halbleiteranordnung mit zwei MOS-Kondensatoren.

In der Figur 2 ist mit den Bezugszeichen 1, 2, 3, 4, 5, 6, 7 und 8 ein Halbleiterkörper, eine Feldoxidschicht, eine erste Polysiliziumschicht, eine Polysiliziumoxidschicht, eine zweite Polysiliziumschicht, eine LTO (low temperature oxid)-Oxidschicht, eine Leitbahnebene und eine Schutzschicht bezeichnet. Hierbei bilden die auf der Feldoxidschicht 2 angeordneten ersten und zweiten Polysiliziumschichten 3a und 5a bzw. 3b und 5b zusammen mit der Siliziumoxidschicht 4a bzw. 4b jeweils einen MOS-Kondensator, die von der LTO-Oxidschicht 6 abgedeckt sind. Die aus Aluminium bestehende Leitbahnebene 7 sowie die LTO-Oxidschicht 6 sind mit einer Schutzschicht 8, beispielsweise aus Siliziumdioxid ($SiO_2$) oder Siliziumnitrid ($Si_3N_4$) überzogen, wobei diese Schichten mittels eines PECVD (plasma enhanced chemical vapour deposition)- oder eines LTO-Verfahrens erzeugt werden. Anschließend wird die Oberfläche 10 dieser Schutzschicht 8 mit HMDS bekeimt, indem in einer HMDS-Bekeimungsanlage Stickstoff ($N_2$) als Trägergas über eine Fritte feinverteilt in HMDS eingeleitet wird. Das mit HMDS beladene Trägergas strömt durch einen Rezipienten, in dem die eigentliche Bekeimung der mit der Schutzschicht passivierten Halbleiteranordnung erfolgt.

Hierbei können die Halbeiteranordnungen in verschiedenen Orientierungen zum Trägergas-Strom in den Rezipienten eingebracht werden, so z.B. in Horizontallage bzw. in Vertikallage bei parallelem Durchfluß des Trägergas-Stromes oder in Vertikallage bei frontalem Durchfluß des Stromes. Es wurde festgestellt, daß in Horizontal- und Vertikallage die Halbleiteranordnungen bei parallelem Trägergas-Strom die Zeitdauer zur gleichmäßigen HMDS-Bekeimung der genannten Oberfläche kleiner ist als bei der zuletzt genannten Orientierung.

Das HMDS reagiert mit Wasser unter Wärmeentwicklung und es entsteht unter Abspaltung von Ammoniak ein hydrophobes Reaktionsprodukt, das in der Figur 2 mit dem Bezugszeichen 11 versehen ist.

Durch diese Behandlung wird die leitende Schicht von der Oberfläche entfernt und damit Oberflächenleckströme verhindert und die parasitären Kapazitäten beseitigt.

Die auf den Halbleiterscheiben angeordneten MOS-Halbleiteranordnungen können nun reproduzierbar gemessen werden.

**Ansprüche**

1) Verfahren zur Herstellung einer integrierten MOS-Halbleiteranordnung für den Niederfrequenzbereich mit auf einem Halbleitersubstrat (1) angeordneten MOS-Bauelementen und Leitbahnen (7), dadurch gekennzeichnet, daß die zwischen diesen Leitbahnen (7) freiliegende Oberfläche (9) hydrophobiert wird.

2) Verfahren zur Herstellung einer integrierten MOS-Halbleiteranordnung für den Niederfrequenzbereich mit auf einem Halbleitersubstrat (1) angeordneten MOS-Bauelementen und Leitbahnen (7), wobei die MOS-Bauelemente und die Leitbahnen (7) mit einer Schutzschicht (8) abgedeckt sind, dadurch gekennzeichnet, daß die Oberfläche (10) der Schutzschicht (8) hydrophobiert wird.

3) Verfahren nach Anspruch 1 oder 2, dadurch gekennzeichnet, daß die Hydrophobierung durch Bekeimung mittels Hexamethyldisilazan (($CH_3$)$_3$SiNHSi($CH_3$)$_3$) erfolgt.

4) Verfahren nach Anspruch 2 oder 3, dadurch gekennzeichnet, daß die Schutzschicht (8) aus einem mittels CVD (chemical vapour deposition)-Verfahren hergestellten Siliziumdioxid ($SiO_2$) besteht.

5) Verfahren nach Anspruch 2 oder 3, dadurch gekennzeichnet, daß die Schutzschicht (8) aus einem mittels PECVP (plasma enhanced chemical vapour deposition)-Verfahren hergestellten Siliziumdioxid ($SiO_2$) besteht.

6) Verfahren nach Anspruch 2 oder 3, dadurch gekennzeichnet, daß die Schutzschicht (8) aus Siliziumnitrid ($Si_3N_4$) besteht.

FIG.1a

FIG.1b

FIG.2

Europäisches
Patentamt

**EUROPÄISCHER
RECHERCHENBERICHT**

Nummer der Anmeldung

**EP 90 11 8960**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 173 683 (COMIZZOLI) <br> * Spalte 1, Zeile 31 - Spalte 2, Zeile 9; Spalte 2, Zeile 62 - Spalte 3, Zeile 2 * <br> — — — | 1-3 | H 01 L <br> 23/522 <br> H 01 L 21/56 |
| Y | | 4-6 | |
| X | US-A-4 628 006 (RATHBURN) <br> * Zusammenfassung; Spalte 1, Zeilen 26-34,50-66 * <br> — — — | 1,3 | |
| Y | S.M. SZE: "VLSI Technology", International Student Edition, 1985, Seite 125, McGraw-Hill, SG <br> * Seite 125, Tafel 5 * <br> — — — — — | 4-6 | |

RECHERCHIERTE
SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| Den Haag | 18 Februar 91 | GREENE S.K. |